# EUROPEAN PATENT APPLICATION

(11) **EP 4 607 581 A1**
(43) Date of publication of application: **27.08.2025**
(21) Application number: 23880131.0
(22) Date of filing: 16.10.2023
(51) Int. Cl.: H01L 23/00, H01L 23/498, C25D 7/00, C25D 5/12

(54) **PLATING APPARATUS FOR MANUFACTURING INTEGRATED CIRCUIT CHIP, PLATING METHOD FOR MANUFACTURING INTEGRATED CIRCUIT CHIP, AND INTEGRATED CIRCUIT CHIP MANUFACTURING METHOD USING SAME**

(30) Priority: 17.10.2022 KR 20220132912
(71) Applicant: Agencomm Co., Ltd, Busan 49315 (KR)
(72) Inventor: KANG, Taehyuk, Siheung-si Gyeonggi-do 15117 (KR)
(74) Representative: Casalonga
(86) International application number: PCT/KR2023/015903
(87) International publication number: WO 2024/085554

(57) **Abstract**

Disclosed are a plating device for manufacturing an integrated circuit (IC) chip, a plating method for manufacturing an IC chip, and a manufacturing method of an IC chip using the same. The disclosed plating device may include a first plating unit including at least one first drum; a second plating unit provided to be spaced apart from the first plating unit and including at least one second drum; and a flexible belt configured to move by being caught on the first drum and the second drum and in which a plurality of IC chip devices is arranged.

## Description

### TECHNICAL FIELD

The present invention relates to an electronic/semiconductor device and an apparatus and method for manufacturing the same, and more particularly, to a plating device for manufacturing an integrated circuit chip, a plating method for manufacturing an integrated circuit chip, and a manufacturing method of an integrated circuit chip using the same.

### RELATED ART

An integrated circuit chip, that is, an IC chip refers to a set of electronic circuits made in a form of a chip by integrating semiconductors and conductors. An integrated circuit may be made dense enough to fit billions of transistors and other electronic components into a fingernail-sized device. The IC chip may be applied to various fields, for example, smart card field such as a smart card, a chip card, and an integrated circuit card.

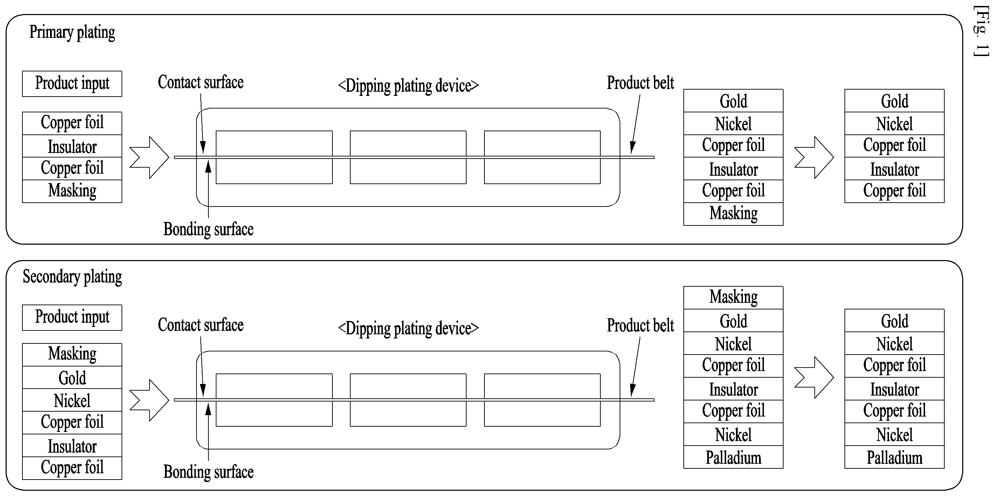

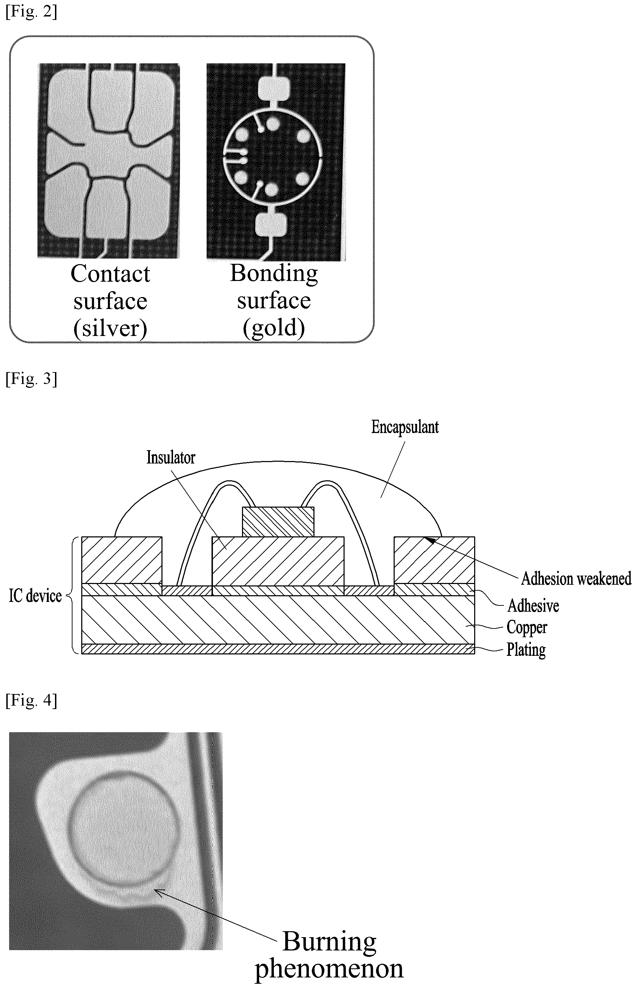

A smart card refers to a plastic card that is embedded with a microprocessor and a memory to store and process information. In general, the smart cards having the same shape and size as those of a credit card is most widely used. Currently, various techniques related to smart cards are rapidly developing. In particular, with the advancement of semiconductor and component technology, the processing power and memory capacity of the smart cards are increasing. The smart cards may be classified into a plurality of types depending on whether a microprocessor is included, an interface method, or a stage of evolution. Such smart cards may be used in many ways from keys people carry to wallets, IDs, and personal computers. Due to this versatility, the size of smart card market is growing at a rapid pace. However, when manufacturing an IC chip applied to the existing smart card, different materials (i.e., differential plating or heterogeneous plating) may need to be plated on bonding surface and contact surface. To perform this differential plating, a plating process needs to be conducted twice using a masking method. For example, after forming a first masking material on the bonding surface, a primary plating process may be conducted on the contact surface. Then, after removing the first masking material from the bonding surface and forming a second masking material on the contact surface, a secondary plating process may be conducted on the bonding surface. Since the plating process needs to be conducted twice using masking, a large amount of time and cost are required. FIG. 1 illustrates the plating process conducted twice according to a conventional method, and FIG. 2 illustrates contact surface and the bonding surface of an IC chip to which differential plating is applied according to the conventional method.

Also, in the case of using the conventional plating method, pressure and heat are applied to a device (i.e., IC device) while masking. Therefore, when forming encapsulant in a post-process, adhesion between the encapsulant and the IC device may be weakened. FIG. 3 is a cross-sectional view illustrating a problem of weakening the adhesion between the encapsulant and the IC device occurring in the conventional method.

In addition, in the case of using the conventional plating method, a difference in a plating area of about 10 times or more is present between an area plated in a bonding hole through which a copper foil is exposed on the bonding surface and an area plated in a remaining portion other than the bonding hole. Therefore, it is difficult to apply efficient silver (Ag) to the bonding surface. When performing Ag plating on the bonding surface, a burning phenomenon occurs due to the difference in the plating area. FIG. 4 is an electron microscope photographic image showing the burning phenomenon occurring in the conventional method.

Accordingly, there is a need for developing a plating device and a plating method for manufacturing an IC chip that may improve and resolve the aforementioned issues found in the conventional method.

### DETAILED DESCRIPTION

### SUBJECT

A technical subject to be achieved by the present invention is to provide a plating device and a plating method for manufacturing an integrated circuit (IC) chip that may easily perform differential plating on both surfaces of a device in one process without using a masking material.

Also, a technical subject to be achieved by the present invention is to provide a plating device and a plating method for manufacturing an IC chip that may easily apply efficient silver (Ag) plating without a burning phenomenon on the bonding surface of the IC chip.

Also, a technical subject to be achieved by the present invention is to provide a method of manufacturing an IC chip to which the aforementioned plating method for manufacturing the IC chip is applied.

The subjects to be solved by the present invention are not limited to the aforementioned subjects and still other subjects not described herein may be clearly understood by one of ordinary skill in the art from the following description.

### SOLUTION

According to example embodiments to accomplish the aforementioned subject, there is provided a plating device for manufacturing an integrated circuit (IC) chip, the plating device including a first plating unit including at least one first drum; a second plating unit provided to be spaced apart from the first plating unit and including at least one second drum; and a flexible belt configured to move by being caught on the first drum and the second drum and in which a plurality of IC chip devices is arranged, wherein the first surface of the flexible belt on which the first surface of the plurality of IC chip devices is exposed is provided to be in contact with the outer circumference of the first drum, and the second surface of the flexible belt on which the second surface opposite to the first surface of the plurality of IC chip devices is exposed is provided to be in contact with the outer circumference of the second drum, the first drum is configured to plate a first material on the first surface by providing a first plating solution to the first surface of the plurality of IC chip devices, and the second drum is configured to plate a second material on the second surface by providing a second plating solution to the second surface of the plurality of IC chip devices.

### EFFECT

According to example embodiments, it is possible to implement a plating device and a plating method for manufacturing an integrated circuit (IC) chip that may easily perform differential plating on both surfaces of a device in one process without using a masking material. Also, according to example embodiments, it is possible to implement a plating device and a plating method for manufacturing an IC chip that may easily apply efficient silver (Ag) plating without a burning phenomenon on the bonding surface of the IC chip.

Using the plating device and the plating method according to example embodiments, it is possible to significantly reduce process cost and process time, and to manufacture an IC chip with excellent characteristics and improved durability.

However, the effects of the present invention are not limited to the aforementioned effects and may be expanded in various ways without departing from the technical spirit and scope of the present invention.

### BRIEF DESCRIPTION OF DRAWINGS

FIG. 1 illustrates a plating process conducted twice according to a conventional method.
FIG. 2 illustrates the contact surface and the bonding surface of an integrated circuit (IC) chip to which differential plating is applied according to the conventional method.
FIG. 3 is a cross-sectional view illustrating a problem of weakening the adhesion between an encapsulant and an IC device occurring in the conventional method.
FIG. 4 is an electron microscope photographic image showing a burning phenomenon occurring in the conventional method.
FIG. 5 illustrates a plating device for manufacturing an IC chip and a plating method using the same according to an example embodiment.
FIG. 6 illustrates a plating device for manufacturing an IC chip and a plating method using the same according to another example embodiment.
FIG. 7 is a photographic image showing an example of a second drum applicable to a plating device for manufacturing an IC chip according to an example embodiment.
FIG. 8 is a photographic image showing a flexible belt hanging on a second drum applicable to a plating device for manufacturing an IC chip according to an example embodiment.
FIG. 9 illustrates a configuration of the contact surface of a flexible belt applicable to a plating device for manufacturing an IC chip according to an example embodiment.
FIG. 10 illustrates a configuration of the bonding surface of a flexible belt applicable to a plating device for manufacturing an IC chip according to an example embodiment.
FIG. 11 illustrates a circuit pattern of the bonding surface in an IC chip device.
FIGS. 12 to 16 are cross-sectional views illustrating various structures of an IC chip that may be manufactured by applying a plating device and a plating method according to example embodiments.
FIG. 17 illustrates various plating conditions applicable to an IC chip for smart card according to an example embodiment.
FIGS. 18 and 19 illustrate a plating device for manufacturing an IC chip and a plating method using the same according to another example embodiment.

### BEST MODE

According to example embodiments to accomplish the aforementioned subject, there is provided a plating device for manufacturing an integrated circuit (IC) chip, the plating device including a first plating unit including at least one first drum; a second plating unit provided to be spaced apart from the first plating unit and including at least one second drum; and a flexible belt configured to move by being caught on the first drum and the second drum and in which a plurality of IC chip devices is arranged, wherein the first surface of the flexible belt on which the first surface of the plurality of IC chip devices is exposed is provided to be in contact with the outer circumference of the first drum, and the second surface of the flexible belt on which the second surface opposite to the first surface of the plurality of IC chip devices is exposed is provided to be in contact with the outer circumference of the second drum, the first drum is configured to plate a first material on the first surface by providing a first plating solution to the first surface of the plurality of IC chip devices, and the second drum is configured to plate a second material on the second surface by providing a second plating solution to the second surface of the plurality of IC chip devices.

The first plating unit may include at least two first drums, and/or the second plating unit may include at least two second drums.

The first plating unit may include a (1-1)-th drum and a (1-2)-th drum corresponding to the first drum, in the flexible belt, the plurality of IC chip devices may be arranged to form a plurality of columns, the (1-1)-th drum may be configured to provide the first plating solution to some of the plurality of columns, and the (1-2)-th drum may be configured to provide the first plating solution to another some of the plurality of columns.

The second plating unit may include a (2-1)-th drum and a (2-2)-th drum corresponding to the second drum, in the flexible belt, the plurality of IC chip devices may be arranged to form a plurality of columns, the (2-1)-th drum may be configured to provide the second plating solution to some of the plurality of columns, and the (2-2)-th drum may be configured to provide the second plating solution to another some of the plurality of columns.

The first drum may be configured to include at least one first platable area formed along its outer circumference and the first platable area may include a first through-hole area, and the first drum may be configured to spray the first plating solution from its inside toward the first through-hole area.

The second drum may be configured to include at least one second platable area formed along its outer circumference, and the second platable area may include a second through-hole area, and the second drum may be configured to spray the second plating solution from its inside toward the second through-hole area.

At least two auxiliary rollers to change a direction of the flexible belt may be further provided between the first plating unit and the second plating unit.

The plating device may further include a third plating unit including at least one third drum, and the second plating unit may be provided between the first plating unit and the third plating unit, the second surface of the flexible belt may be provided to be in contact with the outer circumference of the third drum, and the third drum may be configured to plate a third material on the second surface by providing a third plating solution to the second surface of the plurality of IC chip devices.

The plating device may further include a pre-plating unit configured to plate the same material on the first surface and the second surface of the plurality of IC chip devices using a dipping method; and a strike plating unit configured to perform strike plating on at least one of the first surface and the second surface using the dipping method or a one-side method, and the strike plating unit may be provided between the pre-plating unit and the first plating unit.

The first surface may be the bonding surface of the IC chip, and the second surface may be the contact surface of the IC chip.

The first material may include one of Ag and Au, and the second material may be a material different from the first material.

According to other example embodiments, there is provided a plating method for manufacturing an IC chip, the plating method including preparing a plating device including a first plating unit including at least one first drum, a second plating unit including at least one second drum, and a flexible belt configured to move by being caught on the first drum and the second drum and in which a plurality of IC chip devices is arranged, wherein the first surface of the flexible belt on which the first surface of the plurality of IC chip devices is exposed is provided to be in contact with the outer circumference of the first drum and the second surface of the flexible belt on which the second surface opposite to the first surface of the plurality of IC chip devices is exposed is provided to be in contact with the outer circumference of the second drum; plating a first material on the first surface by providing a first plating solution to the first surface of the plurality of IC chip devices in the first drum, while moving the flexible belt in the plating device; and plating a second material on the second surface by providing a second plating solution to the second surface of the plurality of IC chip devices in the second drum, while moving the flexible belt in the plating device.

The first plating unit may include a (1-1)-th drum and a (1-2)-th drum corresponding to the first drum, in the flexible belt, the plurality of IC chip devices may be arranged to form a plurality of columns, the (1-1)-th drum may be configured to provide the first plating solution to some of the plurality of columns, and the (1-2)-th drum may be configured to provide the first plating solution to another some of the plurality of columns.

The second plating unit may include a (2-1)-th drum and a (2-2)-th drum corresponding to the second drum, in the flexible belt, the plurality of IC chip devices may be arranged to form a plurality of columns, the (2-1)-th drum may be configured to provide the second plating solution to some of the plurality of columns, and the (2-2)-th drum may be configured to provide the second plating solution to another some of the plurality of columns.

The first drum may be configured to include at least one first platable area formed along its outer circumference and the first platable area may include a first through-hole area, and the first drum may be configured to spray the first plating solution from its inside toward the first through-hole area.

The second drum may be configured to include at least one second platable area formed along its outer circumference, and the second platable area may include a second through-hole area, and the second drum may be configured to spray the second plating solution from its inside toward the second through-hole area.

The plating method may further include a pre-plating operation of plating the same material on the first surface and the second surface of the plurality of IC chip devices using a dipping method before plating the first material; and a strike plating operation of performing strike plating on at least one of the first surface and the second surface using the dipping method or a one-side method, between the pre-plating operation and the operation of plating the first material.

The first surface may be the bonding surface of the IC chip, and the second surface may be the contact surface of the IC chip.

The first material may include one of Ag and Au, and the second material may be a material different from the first material.

One plating structure among Condition 1 to Condition 28 below may be applied to the first surface:
Condition 1 : nickel plate/gold plating/silver plating structure
Condition 2 : nickel plate/Au strike plating/gold plating/silver plating/Au strike plating structure
Condition 3 : nickel plate/gold plating/silver plating/Au strike plating structure
Condition 4 : nickel plate/Au strike plating/gold plating/silver plating structure
Condition 5 : nickel plate/Ag strike plating/gold plating/silver plating/Ag strike plating structure
Condition 6 : nickel plate/gold plating/silver plating/Ag strike plating structure
Condition 7 : nickel plate/Ag strike plating/gold plating/silver plating structure
Condition 8 : nickel plate/Pd plating/gold plating/silver plating structure
Condition 9 : nickel plate/Au strike plating/Pd plating/gold plating/silver plating/Au strike plating structure
Condition 10 : nickel plate/Pd plating/gold plating/silver plating/Au strike plating structure
Condition 11 : nickel plate/Au strike plating/Pd plating/gold plating/silver plating structure
Condition 12 : nickel plate/Ag strike plating/Pd plating/gold plating/silver plating/Ag strike plating structure
Condition 13 : nickel plate/Pd plating/gold plating/silver plating/Ag strike plating structure
Condition 14 : nickel plate/Ag strike plating/Pd plating/gold plating/silver plating structure
Condition 15 : nickel plate/silver plating structure
Condition 16 : nickel plate/Au strike plating/silver plating/Au strike plating structure
Condition 17 : nickel plate/silver plating/Au strike plating structure
Condition 18 : nickel plate/Au strike plating/silver plating structure
Condition 19 : nickel plate/Ag strike plating/silver plating/Ag strike plating structure
Condition 20 : nickel plate/silver plating/Ag strike plating structure
Condition 21 : nickel plate/Ag strike plating/silver plating structure
Condition 22 : nickel plate/Pd plating/silver plating structure
Condition 23 : nickel plate/Au strike plating/Pd plating/silver plating/Au strike plating structure
Condition 24 : nickel plate/Pd plating/silver plating/Au strike plating structure
Condition 25 : nickel plate/Au strike plating/Pd plating/silver plating structure
Condition 26 : nickel plate/Ag strike plating/Pd plating/silver plating/Ag strike plating structure
Condition 27 : nickel plate/Pd plating/silver plating/Ag strike plating structure
Condition 28 : nickel plate/Ag strike plating/Pd plating/silver plating structure

According to other example embodiments, there is provided a method of manufacturing an integrated circuit (IC) chip to which the aforementioned plating method is applied.

The IC chip may be an IC chip for smart card.

### MODE

Hereinafter, example embodiments will be described in detail with reference to the accompanying drawings.

The example embodiments to be described below are provided to more clearly explain the present invention to one of ordinary skill in the art and the scope of the present invention is not limited to the following embodiments and the following embodiments may be modified in various forms.

The terms used herein are simply used to describe a specific example embodiment and is not construed to limit the present invention. As used herein, the singular forms "a," "an," and "the" may include the plural form as well, unless the context clearly indicates otherwise. Also, it will be further understood that the terms "comprise" and/or "comprising" when used in this specification, specify the presence of stated features, stages, integers, operations, components, elements and/or groups thereof, do not preclude the presence or addition of one or more other features, stages, integers, operations, components, elements, and/or groups thereof. Also, the term "connect" used in this specification indicates that some components are directly connected and also is the concept of including that another component is further provided and indirectly connected between the components.

In addition, when it is described that a component is present "on" another component, it includes a case in which the component is in contact with the other component and also a case in which still another component is present between the two components. As used herein, the term "and/or" includes any one and any combination of any two or more of the associated listed items. Also, the terms "about," "substantially," etc., used herein are used in the sense of range or close to a numerical value or degree in consideration of unique manufacturing and material tolerance and is used to prevent an infringer from unfairly exploiting the disclosure that states an accurate or absolute numerical value provided to assist understanding of the present application.

Hereinafter, example embodiments are described in detail with reference to the accompanying drawings. Sizes or thicknesses of areas or parts illustrated in the drawings may be exaggerated for clarity of specification and convenience of description. Like reference numerals refer to like elements throughout here.

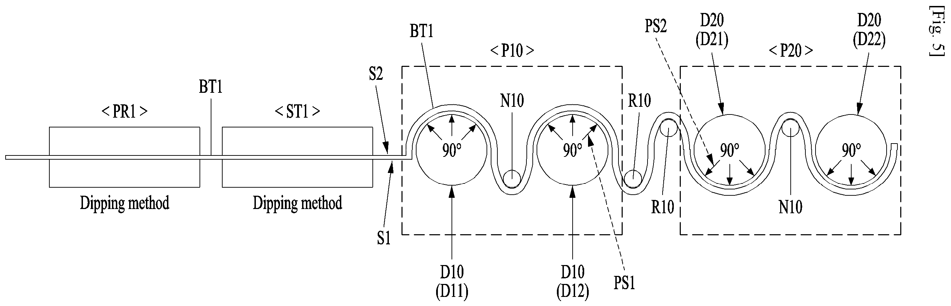

FIG. 5 illustrates a plating device for manufacturing an IC chip and a plating method using the same according to an example embodiment.

Referring to FIG. 5, the plating device for manufacturing the IC chip may include a first plating unit (P10) that includes at least one first drum (D10), a second plating unit (P20) provided to be spaced apart from the first plating unit (P10) and including at least one second drum (D20), and a flexible belt (BT1) configured to move by being caught on the first and second drums (D10 and D20) and in which a plurality of IC chip devices (not shown) is arranged. The flexible belt (BT1) may be a product belt.

The first surface of the flexible belt (BT1) on which the first surface (S1) of the plurality of IC chip devices is exposed may be provided to be in contact with the outer circumference of the first drum (D10), and the second surface of the flexible belt (BT1) on which the second surface (S2) opposite to the first surface (S1) of the plurality of IC chip devices is exposed may be provided to be in contact with the outer circumference of the second drum (D20). Here, the first surface (S1) may be the bonding surface of the IC chip (i.e., IC chip device), and the second surface (S2) may be the contact surface of the IC chip (i.e., IC chip device).

The first drum (D10) may be configured to plate a first material on the first surface (S1) by providing a first plating solution (PS1) to the first surface (S1) of the plurality of IC chip devices. The second drum (D20) may be configured to plate a second material on the second surface (S2) by providing a second plating solution (PS2) to the second surface (S2) of the plurality of IC chip devices. While moving the flexible belt (BT1) from the first plating unit (P10) to the second plating unit (P20), electricity may be applied to a given portion of the plurality of IC chip devices and the first plating solution (PS1) may be provided from the first plating unit (P10) to the first surface (S1), and when the electrically conductive portion comes into contact with the first plating solution (PS1), the first material may be plated on the corresponding portion. Also, similarly, while moving the flexible belt (BT1) from the first plating unit (P10) to the second plating unit (P20), the electricity may be applied to a given portion of the plurality of IC chip devices and the second surface (S2) may be provided from the second plating unit (P20) to the second plating solution (PS2), and when the electrically conductive portion comes into contact with the second plating solution (PS2), the second material may be plated on the corresponding portion.

The first drum (D10) and the second drum (D20) may have an approximately cylindrical or a cylindrical column shape. The first drum (D10) may be configured to include at least one first platable area formed along its outer circumference and the first platable area may include a first through-hole area. The first through-hole area may be formed by penetrating the outer circumference from the inside of the first drum (D10). The first drum (D10) may be configured to spray the first plating solution (PS1) from its inside toward the first through-hole area. The first plating solution (PS1) may pass through the first through-hole area and be sprayed over the first surface (S1) of the IC chip devices. The flexible belt (BT1) may move while contacting a portion (approximately 30 to 70%) of the outer circumference of the first drum (D10), and the first plating solution (PS1) may be sprayed toward a contact area in which the flexible belt (BT1) contacts the first drum (D10) at a spray angle range of, for example, about 90°. However, the spray angle range may be variously changed.

The second drum (D20) may be configured to include at least one second platable area formed along its outer circumference, and the second platable area may include a second through-hole area. The second through-hole area may be formed by penetrating the outer circumference from the inside of the second drum (D20). The second drum (D20) may be configured to spray the second plating solution (PS2) from its inside toward the second through-hole area. The second plating solution (PS2) may pass through the second through-hole area and be sprayed over the second surface (S2) of the IC chip devices. The flexible belt (BT1) may move while contacting a portion (approximately 30 to 70%) of the outer circumference of the second drum (D20), and the second plating solution (PS2) may be sprayed toward a contact area in which the flexible belt (BT1) contacts the second drum (D20) at a spray angle range of, for example, about 90°. However, the spray angle range may be variously changed.

While moving the flexible belt (BT1) in the plating device, the first material may be plated on the first surface (S1) by providing the first plating solution (PS1) to the first surface (S1) of the plurality of IC chip devices in the first drum (D10), and subsequently, the second material may be plated on the second surface (S2) by providing the second plating solution (PS2) to the second surface (S2) of the plurality of IC chip devices in the second drum (D20). The first material and the second material may be different materials. Therefore, according to an example embodiment, using one plating process, "differential plating (heterogeneous plating)" of plating different materials on the first surface (S1) and the second surface (S2) of the IC chip device, respectively, may be performed.

Here, the first surface (S1) may be the bonding surface of the IC chip (i.e., IC chip device), and the second surface (S2) may be the contact surface of the IC chip (i.e., IC chip device). In this case, the first material may include, for example, one of silver (Ag) and gold (Au). The second material may be a material different from the first material. For example, the second material may include one of palladium (Pd), Au, and Ag. However, a specific type of the first material and a specific type of the second material are provided as examples only and may vary depending on cases. Also, depending on cases, the first material and the second material may be of the same series or may be the same material.

Also, although a case in which the first surface (S1) is the bonding surface and the second surface (S2) is the contact surface is mainly described, the first surface (S1) may be the contact surface and the second surface (S2) may be the bonding surface depending on cases. In this case, plating on the contact surface may proceed first and plating on the bonding surface may proceed later. The first material plated on the contact surface and the second material plated on the bonding surface may be appropriately selected.

According to an example embodiment, "differential plating" may be easily performed on both surfaces of the IC chip device through one process without using a masking material. Therefore, compared to the conventional method (see FIG. 1) that needs to perform the plating process twice using the masking material, using the plating device and the plating method according to an example embodiment may significantly reduce process cost and process time.

According to an example, the first plating unit (P10) may include at least two first drums (D10) and/or the second plating unit (P20) may include at least two second drums (D20). For example, the first plating unit (P10) may include a (1-1)-th drum (D11) and a (1-2)-th drum (D12) corresponding to the first drum (D10). In the flexible belt (BT1), the plurality of IC chip devices may be arranged to form a plurality of columns, the (1-1)-th drum (D11) may be configured to provide the first plating solution (PS1) to some of the plurality of columns to perform plating thereon, and the (1-2)-th drum (D12) may provide the first plating solution (PS1) to another some of the plurality of columns to perform plate thereon. As such, using two or more first drums (D10), it is possible to increase efficiency and to reduce plating time.

Also, for example, the second plating unit (P20) may include a (2-1)-th drum (D21) and a (2-2)-th drum (D22) corresponding to the second drum (D20). In the flexible belt (BT1), the plurality of IC chip devices may be arranged to form a plurality of columns, the (2-1)-th drum (D21) may be configured to provide the second plating solution (PS2) to some of the plurality of columns to perform plating thereon, and the (2-2)-th drum (D22) may be configured to provide the second plating solution (PS2) to another some of the plurality of columns to perform plating thereon. As such, using two or more second drums (D20), it is possible to increase efficiency and to reduce plating time.

The plating device according to an example embodiment may further include at least two auxiliary rollers (R10) between the first plating unit (P10) and the second plating unit (P20) to change a direction of the flexible belt (BT1). For example, using two auxiliary rollers (R10), the direction of the flexible belt (BT1) may be changed such that the second surface (S2) comes in contact with the outer circumference of the second drum (D20). However, the number and arrangement of the auxiliary rollers (R10) may variously vary. Also, the plating device may further include intermediate rollers (N10) provided between the (1-1)-th drum (D11) and the (1-2)-th drum (D12), and between the (2-1)-th drum (D21) and the (2-2)-th drum (D22). However, the number and arrangement of the intermediate rollers (N10) may also variously vary.

Also, the plating device according to an example embodiment may further include at least one of a pre-plating unit (PR1) and a strike plating unit (ST1). The plating device may include all of the pre-plating unit (PR1) and the strike plating unit (ST1). In this case, the strike plating unit (ST1) may be provided between the pre-plating unit (PR1) and the first plating unit (P10).

The pre-plating unit (PR1) may be a plating unit for plating the same material on the first surface (S1) and the second surface (S2) of the plurality of IC chip devices using a dipping method. For example, the pre-plating unit (PR1) may be a plating unit that plates nickel (Ni) on the first surface (S1) and the second surface (S2) of the plurality of IC chip devices by dipping the flexible belt (BT1) into electrolyte (plating solution). Here, nickel plating may serve to prevent copper of a copper foil from precipitating into a main plating layer, such as silver, gold, or palladium.

The strike plating unit (ST1) may be a plating unit for performing strike plating on the first surface (S1) and the second surface (S2) of the plurality of IC chip devices using the dipping method on the electrolyte (plating solution). The strike plating may be basic plating performed to improve plating quality and adhesion before performing main plating. The strike plating may be performed to plate Au or Ag at a thickness of about 1 *µ*m or less, for example, at a thin thickness of about 0.003 to 0.01 *µ*m. The strike plating may also be referred to as flash plating.

Meanwhile, a base layer (i.e., matrix layer) of the flexible belt (BT1) may be formed of a polymer such as (silicone), and the plurality of IC chip devices may be formed on the base layer. Therefore, the flexible belt (BT1) in which the plurality of IC chip devices is arranged may also be referred to as, for example, a silicone belt. However, main material composition of the flexible belt (BT1) may vary.

In addition, the plating device according to an example embodiment, may be a reel-to-reel plating device. In this case, both ends of the flexible belt (BT1) are wound on the reels, respectively, and the flexible belt (BT1) may continuously move in response to rotation of the reels.

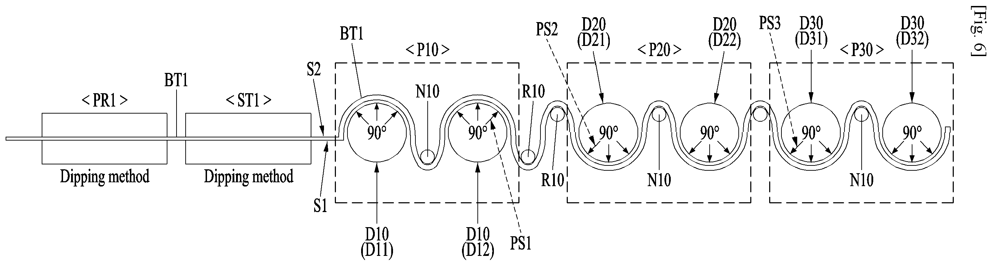

FIG. 6 illustrates a plating device for manufacturing an IC chip and a plating method using the same according to another example embodiment.

Referring to FIG. 6, the plating device for manufacturing the IC chip according to the example embodiment may further include a third plating unit (P30) compared to the plating device of FIG. 5. The third plating unit (P30) may include at least one third drum (D30). The second plating unit (P20) may be provided between the first plating unit (P10) and the third plating unit (P30). Therefore, the first plating unit (P10) and the second plating unit (P20) and the third plating unit (P30) may be sequentially arranged. The second surface of the flexible belt (BT1) on which the second surface (S2) of the plurality of IC chip devices is exposed may be provided to be in contact with the outer circumference of the third drum (D30). The third drum (D30) may be configured to plate a third material on the second surface (S2) by providing a third plating solution (PS3) to the second surface (S2) of the plurality of IC chip devices.

The third drum (D30) may have an approximately cylindrical or a cylindrical column shape. The third drum (D30) may be configured to include at least one third platable area formed along its outer circumference, and the third platable area may include a third through-hole area. The third through-hole area may be formed by penetrating the outer circumference from the inside of the third drum (D30). The third drum (D30) may be configured to spray the third plating solution (PS3) from its inside toward the third through-hole area. The third plating solution (PS3) may pass through the third through-hole area and be sprayed over the second surface (S2) of the IC chip device. The flexible belt (BT1) may move while contacting a portion (approximately 30 to 70%) of the outer circumference of the third drum (D30), and the third plating solution (PS3) may be sprayed toward a contact area in which the flexible belt (BT1) contacts the third drum (D30) at a spray angle range of, for example, about 90°. However, the spray angle range may be variously changed.

According to an example, the third plating unit (P30) may include at least two third drums (D30). For example, the third plating unit (P30) may include a (3-1)-th drum (D31) and a (3-2)-th drum (D32) corresponding to the third drum (D30). In the flexible belt (BT1), the plurality of IC chip devices may be arranged to form the plurality of columns, the (3-1)-th drum (D31) may be configured to provide the third plating solution (PS3) to some of the plurality of columns to perform plating thereon, and the (3-2)-th drum (D32) may be configured to provide the third plating solution (PS3) to another some of the plurality of columns to perform plating thereon. As such, using two or more third drums (D30), it is possible to increase efficiency and to reduce plating time.

In the example embodiment, when performing this plating (main plating) on the second surface (S2), one of the second plating unit (P20) and the third plating unit (P30) may be selectively used. For example, when the second material is desired to be plated on the second surface (S2), the second plating unit (P20) may be effectively operated and the third plating unit (P30) may be configured to rotate only the third drum (D30) without an actual plating operation. Meanwhile, when the third material is desired to be plated on the second surface (S2), the third plating unit (P30) may be effectively operated and the second plating unit (P20) may be configured to rotate only the second drum (D20) without an actual plating operation. Therefore, depending on a type of a product (IC chip), the efficiency of a process and management may be improved by selectively using one of the second plating unit (P20) and the third plating unit (P30). For similar reasons, if necessary, a plurality of first plating units (P10) may be provided and one of the plurality of first plating units (P10) may be selectively used.

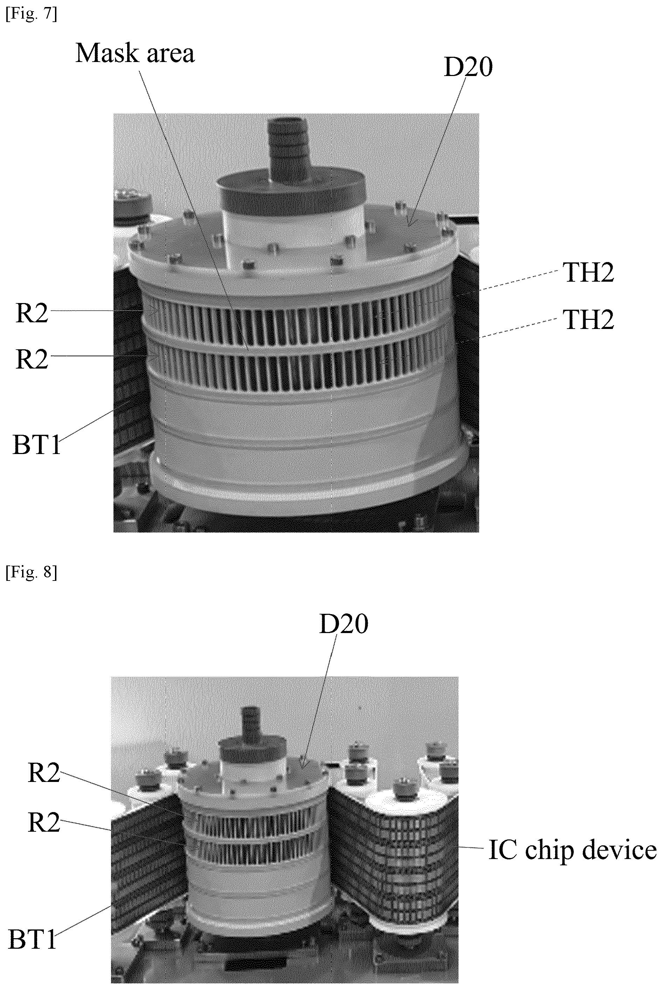

FIG. 7 is a photographic image showing an example of the second drum (D20) applicable to a plating device for manufacturing an IC chip according to an example embodiment.

FIG. 8 is a photographic image showing the flexible belt (BT1) hanging on the second drum (D20) applicable to a plating device for manufacturing an IC chip according to an example embodiment.

Referring to FIGS. 7 and 8, the second drum (D20) applicable to the plating device for manufacturing the IC chip according to an example embodiment may be configured to include at least one second platable area (R2) formed along its outer circumference, each second platable area (R2) may include a second through-hole area (TH2), and the second drum (D20) may be configured to spray the second plating solution (PS2 of FIG. 5) from its inside toward the second through-hole area (TH2). The second through-hole area (TH2) may be partitioned by, for example, a plurality of vertical rib members. For example, the outer circumference of the second drum (D20) may be divided into four unit areas, and the second platable area (R2) may be formed in upper two unit areas among the four unit areas. Lower two unit areas among the four unit areas may be blocked. A width of one unit area may be about 150 mm, but it is provided as an example and may variously vary. Also, a mask area may be present between the unit areas and at a top and bottom. The mask area may serve to cover the corresponding portion of the flexible belt (BT1) such that the plating solution is not in contact with the corresponding portion of the flexible belt (BT1). The mask area may be a somewhat protruding structure.

In the flexible belt (BT1), the plurality of IC chip devices may be arranged to form the plurality of columns, and the second drum (D20) may be configured to provide the second plating solution (PS2 of FIG. 5) to some of the plurality of columns. The second drum (D20) may be configured to perform corresponding plating on IC chip devices that move in contact with a portion in which the second platable area (R2) is formed.

The second drum (D20) of FIGS. 7 and 8 may correspond to, for example, the (2-1)-th drum (D21) of FIG. 5. In this case, the (2-2)-th drum (D22) of FIG. 5 may have a structure similar to the structure of FIG. 7, and may have a structure in which the second platable area (R2) is formed in lower two unit areas rather than the upper two unit areas. Here, the (2-2)-th drum (D22) may perform corresponding plating on IC chip devices moving in contact with the lower two unit areas. Therefore, using the (2-1)-th drum (D21) and the (2-2)-th drum (D22) of FIG. 5, plating on the second surface (S2 of FIG. 5) may be performed for all of the plurality of IC chip devices.

The structure of the (2-1)-th drum (D21) and the (2-2)-th drum (D22) described with reference to FIGS. 7 and 8 may be applied similarly or identically to the (1-1)-th drum (D11) and the (1-2)-th drum (D12) and the (3-1)-th drum (D31) and the (3-2)-th drum (D32). However, a specific form of a drum described with reference to FIGS. 7 and 8 is provided as an example only and may be variously changed if necessary.

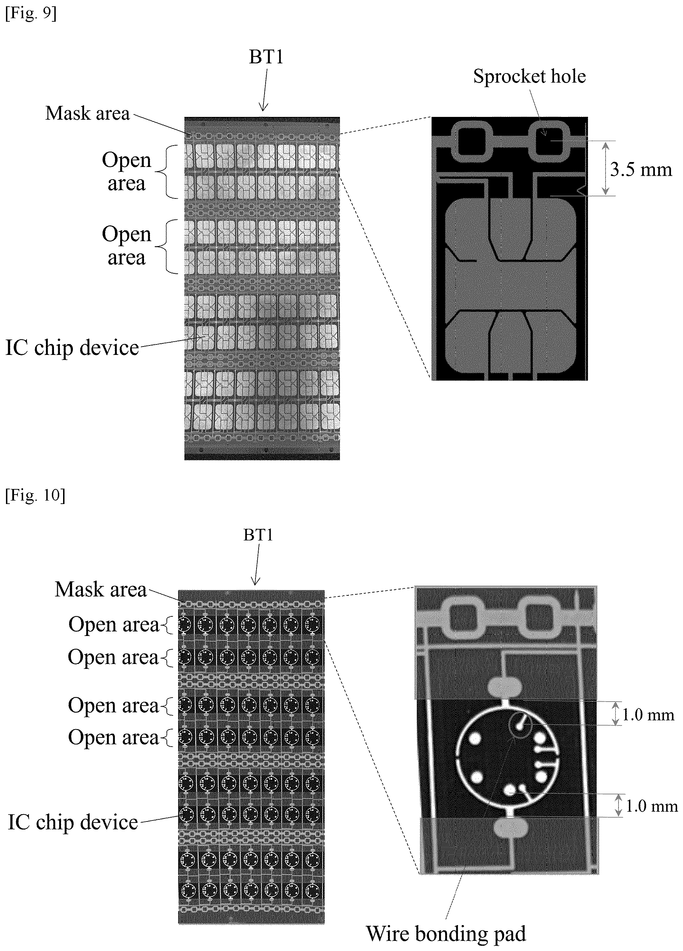

FIG. 9 illustrates a configuration of the contact surface of the flexible belt (BT1) applicable to a plating device for manufacturing an IC chip according to an example embodiment.

Referring to FIG. 9, the flexible belt (BT1) applicable to the plating device for manufacturing the IC chip according to an example embodiment may include a configuration in which the plurality of IC chip devices is arranged. The plurality of IC chip devices may be arranged to form the plurality of columns in an extension direction of the flexible belt (BT1). The plurality of IC chip devices may be regularly arranged to form a plurality of columns and a plurality of rows.

An "open area" in FIG. 9 may correspond to the platable area (R2) of the drum (D20) described in FIG. 7. Also, a "mask area" in FIG. 9 may correspond to the mask area of the drum (D20) described in FIG. 7. The mask area may correspond to a silicone port that protrudes from the outer circumference of the drum. Plating may be performed by selectively opening a partial area to be plated in the IC chip device. As a detailed example, as shown in an image on the right in FIG. 9, the drum (second drum) may be designed to not invade an IC chip device within about 3.5 mm from a sprocket hole center toward the inside of the IC chip device and silicone in the mask area may be designed to correspond thereto. However, such specific dimensional range is provided as an example only and may be variously changed depending on cases.

FIG. 10 illustrates a configuration of the bonding surface of the flexible belt (BT1) applicable to a plating device for manufacturing an IC chip according to an example embodiment.

Referring to FIG. 10, the flexible belt (BT1) applicable to the plating device for manufacturing the IC chip according to an example embodiment may include a configuration in which the plurality of IC chip devices is arranged. An "open area" in FIG. 10 may correspond to the first platable area of the first drum (D10) in FIG. 5. A "mask area" in FIG. 10 may correspond to the mask area of the first drum (D10). The mask area may correspond to a silicone portion that protrudes from the outer circumference of the first drum (D10). Plating may be performed by selectively opening a partial area to be plated in the IC chip device. As a detailed example, as shown in an image on the right in FIG. 10, the open area in the first drum may be designed with a gap of at least about 1 mm from an outermost wire bonding pad and silicone in the mask area may be designed to correspond thereto. However, such specific dimensional range is provided as an example only and may be variously changed depending on cases.

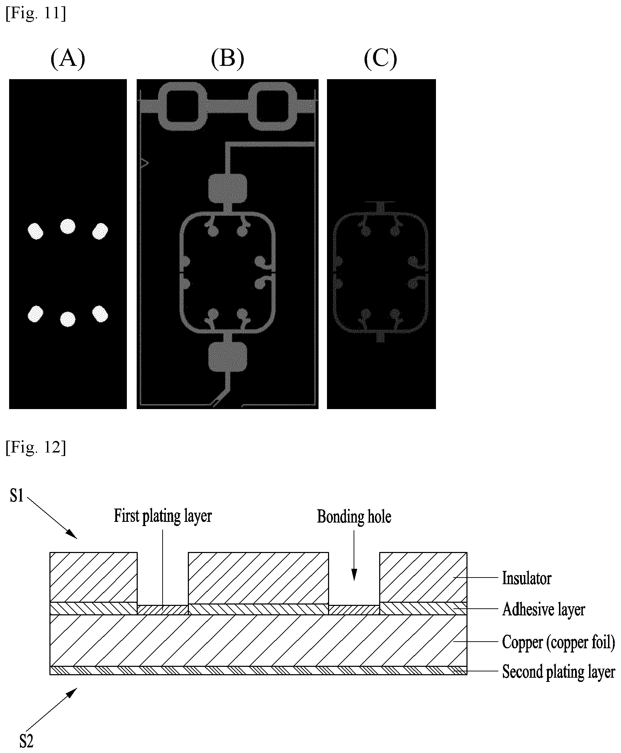

FIG. 11 illustrates a circuit pattern of the bonding surface in an IC chip device. (A) of FIG. 11 shows an area plated in a bonding hole through which a copper foil adjacent to the contact surface is exposed on the bonding surface. (B) of FIG. 11 shows an area plated in a remaining portion other than the bonding hole on the bonding surface according to the conventional plating method. (C) of FIG. 11 shows an area plated in the remaining portion other than the bonding hole on the bonding surface according to an example embodiment.

Comparing (A) and (B) of FIG. 11, in the case of using the conventional plating method, a difference in plating area of about 10 times or more occurs between the area plated in the bonding hole through which the copper foil adjacent to the contact surface is exposed on the bonding surface (A) and the area plated in the remaining portion other than the bonding hole (B). That is, a plating area corresponding to (A) may be about 3.5 mm² and a plating area corresponding to (B) may be about 36.22 mm², which leads to an area difference of about 10.35 times. Therefore, it is difficult to apply efficient silver (Ag) plating to the bonding surface. If Ag plating is performed on the bonding surface, a burning phenomenon occurs as shown in FIG. 4 due to the difference in plating area.

Comparing (A) and (C) of FIG. 11, in the case of using the plating method according to an example embodiment, the difference in plating area may significantly decrease between the area plated in the bonding hole through which the copper foil adjacent to the contact surface is exposed on the bonding surface (A) and the area plated in the remaining portion other than the bonding hole (C). That is, a plating area corresponding to (A) may be about 3.5 mm² and a plating area corresponding to (C) may be about 6.8 mm², which may lead to an area difference of about 1.94 times. Therefore, it is possible to easily apply efficient silver (Ag) plating to the bonding surface, without a burning phenomenon.

By applying the plating device and the plating method according to example embodiments, the IC chip may be manufactured. Here, the IC chip may be, for example, an IC chip for smart card.

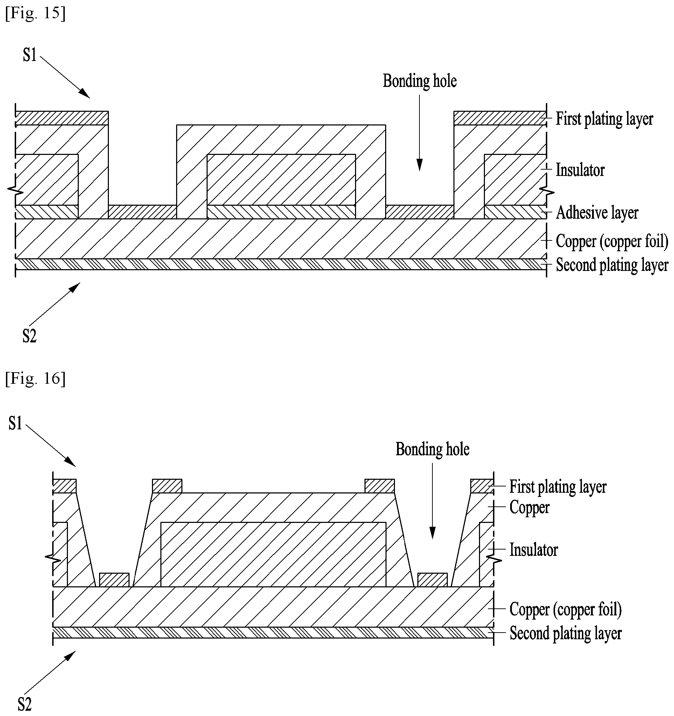

FIGS. 12 to 16 are cross-sectional views illustrating various structures of an IC chip that may be manufactured by applying a plating device and a plating method according to example embodiments. Here, the IC chip may be an IC chip for smart card.

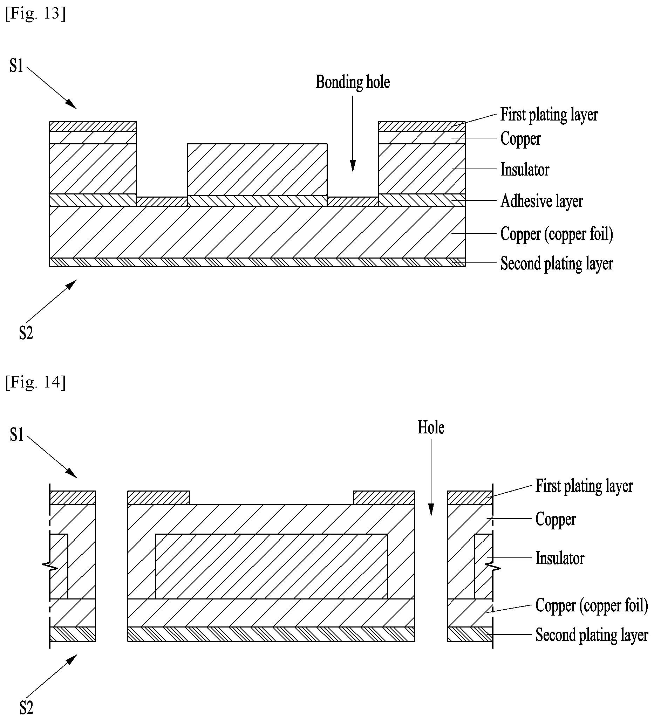

In FIGS. 12 to 16, S1 represents the bonding surface, and S2 represents the contact surface. In FIGS. 12 to 17, an insulator may include an insulating polymer such as epoxy or other insulating material. The IC chip in FIG. 12 may be in a single structure and the IC chip in FIGS. 13 to 16 may be in a dual structure. However, the structures of the IC chip illustrated in FIGS. 12 to 16 are provided as examples only and the plating device and the plating method according to an example embodiment may be applied to various chip structures.

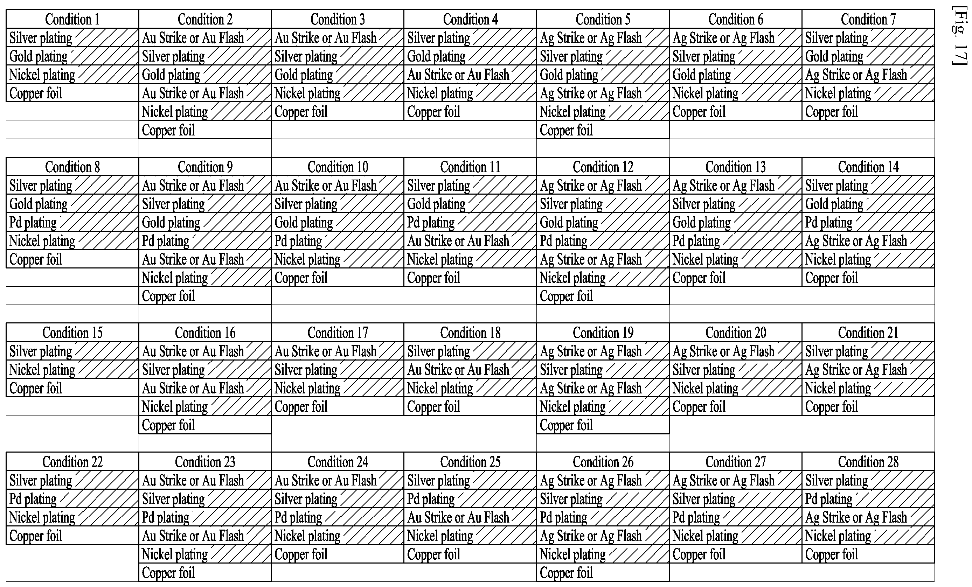

FIG. 17 illustrates various plating conditions applicable to an IC chip for smart card according to an example embodiment. In the structures of FIGS. 12 to 16, plating of a portion indicated with hatching in FIG. 17 may be applied to a "first plating layer" on the bonding surface (i.e., S1) in a reel-to-reel manner. In particular, performing silver plating on the bonding surface while performing differential plating on both surfaces of the IC chip for smart card may be a new method that was unable to be implemented in the art.

As shown in FIG. 17, according to example embodiments, one plating structure among the following Condition 1 to Condition 28 from the copper foil may be implemented/applied to the first surface (S1) (e.g., bonding surface) of the IC chip for smart card.
Condition 1 : nickel plate/gold plating/silver plating structure
Condition 2 : nickel plate/Au strike plating/gold plating/silver plating/Au strike plating structure
Condition 3 : nickel plate/gold plating/silver plating/Au strike plating structure
Condition 4 : nickel plate/Au strike plating/gold plating/silver plating structure
Condition 5 : nickel plate/Ag strike plating/gold plating/silver plating/Ag strike plating structure
Condition 6 : nickel plate/gold plating/silver plating/Ag strike plating structure
Condition 7 : nickel plate/Ag strike plating/gold plating/silver plating structure
Condition 8 : nickel plate/Pd plating/gold plating/silver plating structure
Condition 9 : nickel plate/Au strike plating/Pd plating/gold plating/silver plating/Au strike plating structure
Condition 10 : nickel plate/Pd plating/gold plating/silver plating/Au strike plating structure
Condition 11 : nickel plate/Au strike plating/Pd plating/gold plating/silver plating structure
Condition 12 : nickel plate/Ag strike plating/Pd plating/gold plating/silver plating/Ag strike plating structure
Condition 13 : nickel plate/Pd plating/gold plating/silver plating/Ag strike plating structure
Condition 14 : nickel plate/Ag strike plating/Pd plating/gold plating/silver plating structure
Condition 15 : nickel plate/silver plating structure
Condition 16 : nickel plate/Au strike plating/silver plating/Au strike plating structure
Condition 17 : nickel plate/silver plating/Au strike plating structure
Condition 18 : nickel plate/Au strike plating/silver plating structure
Condition 19 : nickel plate/Ag strike plating/silver plating/Ag strike plating structure
Condition 20 : nickel plate/silver plating/Ag strike plating structure
Condition 21 : nickel plate/Ag strike plating/silver plating structure
Condition 22 : nickel plate/Pd plating/silver plating structure
Condition 23 : nickel plate/Au strike plating/Pd plating/silver plating/Au strike plating structure
Condition 24 : nickel plate/Pd plating/silver plating/Au strike plating structure
Condition 25 : nickel plate/Au strike plating/Pd plating/silver plating structure
Condition 26 : nickel plate/Ag strike plating/Pd plating/silver plating/Ag strike plating structure
Condition 27 : nickel plate/Pd plating/silver plating/Ag strike plating structure
Condition 28 : nickel plate/Ag strike plating/Pd plating/silver plating structure

In the aforementioned conditions, the term "strike plating" may be replaced with "flash plating," which may be applied to the entire specification.

In addition, according to another example embodiment, in the plating device for manufacturing the IC chip and the plating method using the same, a one-side plating method rather than a dipping method may be applied when performing strike plating (or flash plating).

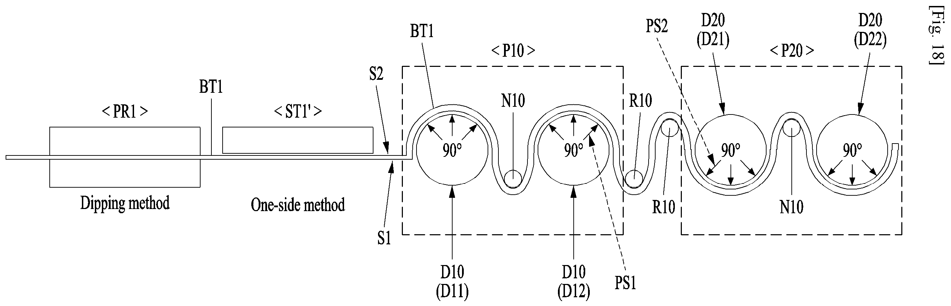

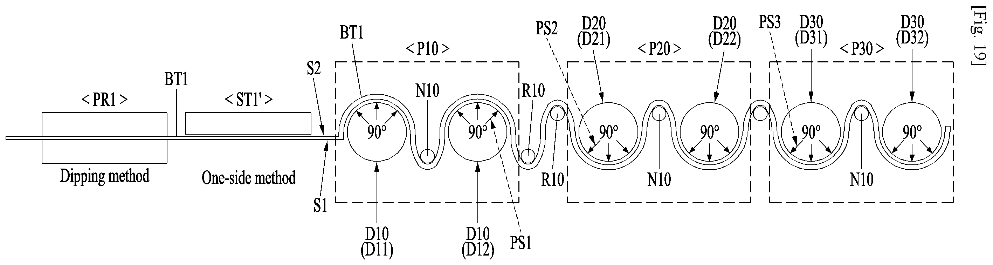

FIGS. 18 and 19 illustrate a plating device for manufacturing an IC chip and a plating method using the same according to another example embodiment.

FIG. 18 illustrates a case in which the strike plating unit (ST1) of the dipping method in FIG. 5 is changed to the strike plating unit (ST1') of the one-side method, and FIG. 19 illustrates a case in which the strike plating unit (ST1) of the dipping method in FIG. 6 is changed to the strike plating unit (ST1') of the one-side method. The strike plating unit (ST1') of the one-side method may be configured to perform strike plating only on the first surface (S1) or the second surface (S2). The shape and position of the strike plating unit (ST1') shown in FIGS. 18 and 19 are provided as examples only and may vary.

According to example embodiments described above, it is possible to implement a plating device and a plating method for manufacturing an IC chip that may easily perform differential plating on both surfaces of a device in one process without forming a masking material. Also, according to example embodiments, it is possible to implement a plating device and a plating method for manufacturing an IC chip that may easily apply efficient Ag plating without a burning phenomenon on the bonding surface of an IC chip. Using the plating device and the plating method according to example embodiments, it is possible to significantly reduce process cost and process time, and to manufacture an IC chip with excellent characteristics and improved durability.

Herein, the example embodiments are disclosed and although specific terms are used, they are merely used in general sense to easily explain the technical contents of the present invention and to assist understanding of the invention and should be understood to not limit the scope of the present invention. It is obvious to one of ordinary skill in the art to which the present invention pertains that other modifications based on the technical spirit of the present invention may be implemented in addition to the example embodiments disclosed herein. For example, it will be apparent to one of ordinary skill in the art that the plating device for manufacturing the IC chip, the plating method for manufacturing the IC chip, and the manufacturing method of the IC chip using the same according to example embodiments described with reference to FIGS. 5 to 19 may be modified in various ways. As a detailed example, the plating device and the plating method may be applied to manufacturing the IC chip for smart card, but in some cases, may be applied to manufacture of the IC chip in fields other than the smart card. Therefore, the scope of the invention should not be determined by the described example embodiments, but should be defined by the technical idea stated in the claims.

## Claims

1. A plating device for manufacturing an integrated circuit (IC) chip, the plating device comprising:
a first plating unit including at least one first drum;
a second plating unit provided to be spaced apart from the first plating unit and including at least one second drum; and
a flexible belt configured to move by being caught on the first drum and the second drum and in which a plurality of IC chip devices is arranged,
wherein the first surface of the flexible belt on which the first surface of the plurality of IC chip devices is exposed is provided to be in contact with the outer circumference of the first drum, and the second surface of the flexible belt on which the second surface opposite to the first surface of the plurality of IC chip devices is exposed is provided to be in contact with the outer circumference of the second drum,
the first drum is configured to plate a first material on the first surface by providing a first plating solution to the first surface of the plurality of IC chip devices, and
the second drum is configured to plate a second material on the second surface by providing a second plating solution to the second surface of the plurality of IC chip devices.

2. The plating device of claim 1, wherein the first plating unit includes at least two first drums, and/or
the second plating unit includes at least two second drums.

3. The plating device of claim 1, wherein the first plating unit includes a (1-1)-th drum and a (1-2)-th drum corresponding to the first drum,
in the flexible belt, the plurality of IC chip devices is arranged to form a plurality of columns,
the (1-1)-th drum is configured to provide the first plating solution to some of the plurality of columns, and the (1-2)-th drum is configured to provide the first plating solution to another some of the plurality of columns.

4. The plating device of claim 1, wherein the second plating unit includes a (2-1)-th drum and a (2-2)-th drum corresponding to the second drum,
in the flexible belt, the plurality of IC chip devices is arranged to form a plurality of columns,
the (2-1)-th drum is configured to provide the second plating solution to some of the plurality of columns, and the (2-2)-th drum is configured to provide the second plating solution to another some of the plurality of columns.

5. The plating device of claim 1, wherein the first drum is configured to include at least one first platable area formed along its outer circumference and the first platable area includes a first through-hole area, and
the first drum is configured to spray the first plating solution from its inside toward the first through-hole area.

6. The plating device of claim 1, wherein the second drum is configured to include at least one second platable area formed along its outer circumference, and the second platable area includes a second through-hole area, and
the second drum is configured to spray the second plating solution from its inside toward the second through-hole area.

7. The plating device of claim 1, wherein at least two auxiliary rollers to change a direction of the flexible belt are further provided between the first plating unit and the second plating unit.

8. The plating device of claim 1, wherein the plating device further comprises a third plating unit including at least one third drum, and the second plating unit is provided between the first plating unit and the third plating unit,
the second surface of the flexible belt is provided to be in contact with the outer circumference of the third drum, and
the third drum is configured to plate a third material on the second surface by providing a third plating solution to the second surface of the plurality of IC chip devices.

9. The plating device of claim 1, wherein the plating device further comprises:
a pre-plating unit configured to plate the same material on the first surface and the second surface of the plurality of IC chip devices using a dipping method; and
a strike plating unit configured to perform strike plating on at least one of the first surface and the second surface using the dipping method or a one-side method, and
the strike plating unit is provided between the pre-plating unit and the first plating unit.

10. The plating device of claim 1, wherein the first surface is the bonding surface of the IC chip, and
the second surface is the contact surface of the IC chip.

11. The plating device of claim 1, wherein the first material includes one of Ag and Au, and the second material is a material different from the first material.

12. A plating method for manufacturing an integrated circuit (IC) chip, the plating method comprising:
preparing a plating device comprising a first plating unit including at least one first drum, a second plating unit including at least one second drum, and a flexible belt configured to move by being caught on the first drum and the second drum and in which a plurality of IC chip devices is arranged, wherein the first surface of the flexible belt on which the first surface of the plurality of IC chip devices is exposed is provided to be in contact with the outer circumference of the first drum and the second surface of the flexible belt on which the second surface opposite to the first surface of the plurality of IC chip devices is exposed is provided to be in contact with the outer circumference of the second drum;
plating a first material on the first surface by providing a first plating solution to the first surface of the plurality of IC chip devices in the first drum, while moving the flexible belt in the plating device; and
plating a second material on the second surface by providing a second plating solution to the second surface of the plurality of IC chip devices in the second drum, while moving the flexible belt in the plating device.

13. The plating method of claim 12, wherein the first plating unit includes a (1-1)-th drum and a (1-2)-th drum corresponding to the first drum, in the flexible belt, the plurality of IC chip devices is arranged to form a plurality of columns,
the (1-1)-th drum is configured to provide the first plating solution to some of the plurality of columns, and the (1-2)-th drum is configured to provide the first plating solution to another some of the plurality of columns.

14. The plating method of claim 12, wherein the second plating unit includes a (2-1)-th drum and a (2-2)-th drum corresponding to the second drum, in the flexible belt, the plurality of IC chip devices is arranged to form a plurality of columns,
the (2-1)-th drum is configured to provide the second plating solution to some of the plurality of columns, and the (2-2)-th drum is configured to provide the second plating solution to another some of the plurality of columns.

15. The plating method of claim 12, wherein the first drum is configured to include at least one first platable area formed along its outer circumference and the first platable area includes a first through-hole area, and
the first drum is configured to spray the first plating solution from its inside toward the first through-hole area.

16. The plating method of claim 12, wherein the second drum is configured to include at least one second platable area formed along its outer circumference, and the second platable area includes a second through-hole area, and
the second drum is configured to spray the second plating solution from its inside toward the second through-hole area.

17. The plating method of claim 12, wherein the plating method further comprises:
a pre-plating operation of plating the same material on the first surface and the second surface of the plurality of IC chip devices using a dipping method before plating the first material; and
a strike plating operation of performing strike plating on at least one of the first surface and the second surface using the dipping method or a one-side method, between the pre-plating operation and the operation of plating the first material.

18. The plating method of claim 12, wherein the first surface is the bonding surface of the IC chip, and
the second surface is the contact surface of the IC chip.

19. The plating method of claim 12, wherein the first material includes one of Ag and Au, and the second material is a material different from the first material.

20. The plating method of claim 12, wherein one plating structure among Condition 1 to Condition 28 below is applied to the first surface:
Condition 1 : nickel plate/gold plating/silver plating structure
Condition 2 : nickel plate/Au strike plating/gold plating/silver plating/Au strike plating structure
Condition 3 : nickel plate/gold plating/silver plating/Au strike plating structure Condition 4 : nickel plate/Au strike plating/gold plating/silver plating structure
Condition 5 : nickel plate/Ag strike plating/gold plating/silver plating/Ag strike plating structure
Condition 6 : nickel plate/gold plating/silver plating/Ag strike plating structure Condition 7 : nickel plate/Ag strike plating/gold plating/silver plating structure Condition 8 : nickel plate/Pd plating/gold plating/silver plating structure
Condition 9 : nickel plate/Au strike plating/Pd plating/gold plating/silver plating/Au strike plating structure
Condition 10 : nickel plate/Pd plating/gold plating/silver plating/Au strike plating structure
Condition 11 : nickel plate/Au strike plating/Pd plating/gold plating/silver plating structure
Condition 12 : nickel plate/Ag strike plating/Pd plating/gold plating/silver plating/Ag strike plating structure
Condition 13 : nickel plate/Pd plating/gold plating/silver plating/Ag strike plating structure
Condition 14 : nickel plate/Ag strike plating/Pd plating/gold plating/silver plating structure
Condition 15 : nickel plate/silver plating structure
Condition 16 : nickel plate/Au strike plating/silver plating/Au strike plating structure
Condition 17 : nickel plate/silver plating/Au strike plating structure
Condition 18 : nickel plate/Au strike plating/silver plating structure
Condition 19 : nickel plate/Ag strike plating/silver plating/Ag strike plating structure
Condition 20 : nickel plate/silver plating/Ag strike plating structure
Condition 21 : nickel plate/Ag strike plating/silver plating structure
Condition 22 : nickel plate/Pd plating/silver plating structure
Condition 23 : nickel plate/Au strike plating/Pd plating/silver plating/Au strike plating structure
Condition 24 : nickel plate/Pd plating/silver plating/Au strike plating structure
Condition 25 : nickel plate/Au strike plating/Pd plating/silver plating structure
Condition 26 : nickel plate/Ag strike plating/Pd plating/silver plating/Ag strike plating structure
Condition 27 : nickel plate/Pd plating/silver plating/Ag strike plating structure
Condition 28 : nickel plate/Ag strike plating/Pd plating/silver plating structure

21. A manufacturing method of an integrated circuit (IC) chip to which the plating method of one of claims 12 to 20 is applied.

22. The manufacturing method of claim 21, wherein the IC chip is an IC chip for smart card.
